Europäisches Patentamt

European Patent Office

Office européen des brevets

(19)

(11) **EP 0 561 451 B1**

(12) **EUROPEAN PATENT SPECIFICATION**

(45) Date of publication and mention
of the grant of the patent:
**12.08.1998 Bulletin 1998/33**

(51) Int Cl.⁶: **H01L 27/02**

(21) Application number: 93200667.9

(22) Date of filing: **09.03.1993**

(54) **Integrated semiconductor circuit including protection means**

Integrierte Halbleiterschaltung mit Schutzvorrichtungen

Circuit semiconducteur intégré comprenant des moyens de protection

(84) Designated Contracting States:
**DE FR GB**

(30) Priority: **16.03.1992 EP 92200740**

(43) Date of publication of application:
**22.09.1993 Bulletin 1993/38**

(73) Proprietor: **Philips Electronics N.V.**
**5621 BA Eindhoven (NL)**

(72) Inventor: **Muhlemann, Kurt,**
**c/o Int. Octrooibureau B.V.**
**NL-5656 AA Eindhoven (NL)**

(74) Representative: **de Haas, Laurens Johan et al**
**INTERNATIONAAL OCTROOIBUREAU B.V.,**
**Prof. Holstlaan 6**
**5656 AA Eindhoven (NL)**

(56) References cited:
**EP-A- 0 217 525          EP-A- 0 360 991**

• **PROCEEDINGS OF THE IEEE 1987 CUSTOM
INTEGRATED CIRCUITS CONFERENCE (CAT.
NO.87CH2430-7), PORTLAND, OR, USA, 4-7 MAY
1987, 1987, NEW YORK, NY, USA, IEEE, USA,
pages 267-267, MUHLEMANN K ET AL 'A 30 V
row/column driver for flat-panel liquid crystal
displays'**

## Description

The invention relates to a circuit which is integrated on a semiconductor substrate for level conversion or for driving a load (for example, VFD = Vacuum Fluorescence Displays) with a comparatively high voltage (for example, 35 V) and which comprises a first and a second supply voltage terminal for application of a comparatively high voltage, an input and an output, there also being provided a switching transistor, a protection transistor and a sub-circuit, the gate of the switching transistor being connected to the input, the source of the switching transistor being connected to the first power supply terminal, the drain of the switching transistor being coupled to the source of the protection transistor and the drain of the protection transistor being coupled to the second supply terminal via the sub-circuit for supplying a signal for the sub-circuit during operation, an output of the sub-circuit being connected to the output and the gate of the protection transistor receiving a fixed voltage,

A circuit of this kind is known from Proceedings of the IEEE Custom Integrated Circuits Conference, Portland, Oregon, May 4-7, 1987, pp. 267-271. In circuits of this kind it is important to ensure that no breakdowns occur in any location due to excessive field strengths especially at the drain or gate junctions.

It is an object of the invention to propose a circuit integrated on a semiconductor substrate in which the vulnerability of the circuit to the comparatively high voltage for driving the load connected to the circuit is substantially reduced or even eliminated, without additional technology and without complex process steps being used.

An integrated circuit according to the present invention is defined in claim 1.

An integrated circuit on a semiconductor substrate in accordance with the invention is characterized in that the gate of the protection transistor is connected to the second power supply terminal, the gate of the protection transistor is provided on the field oxide layer of the integrated circuit to limit the voltage at the drain of the switching transistor. Because the gate of the protection transistor is provided on the field-oxide layer of the integrated circuit in accordance with the invention, the threshold voltage prevents the occurrence of a breakdown at the drain diode of the switching transistor during operation, because the potential at the drain of the switching transistor remains limited. The protection transistor is turned off already before the drain potential of the switching transistor has dropped so far that a breakdown of the cited diode occurs.

Further embodiments of the integrated circuit in accordance with the invention are defined in claims 2-15.

The invention will be described in detail hereinafter with reference to embodiments shown in a drawing; therein:

Figs. 1A, B, C and D show a preferred embodiment of a circuit in accordance with the invention;
Figs. 2A and B show an embodiment of a circuit useful for understanding the invention;
Fig. 3 shows a further embodiment of a circuit in accordance with the invention, and
Fig. 4 shows an embodiment of a circuit in accordance with the invention which can be integrated on a p-substrate.

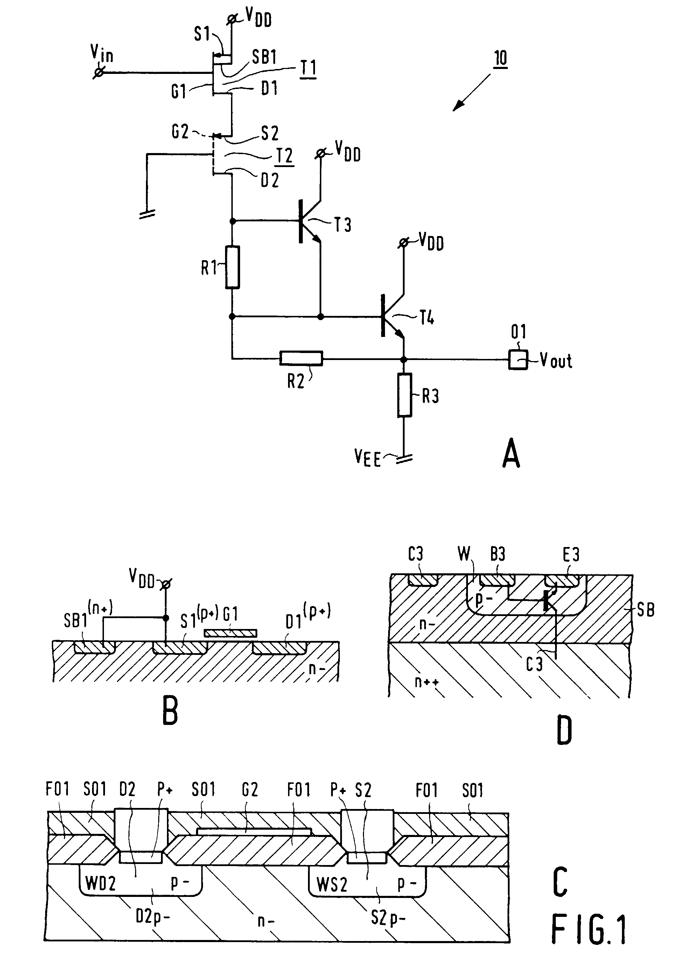

Fig. 1A shows a preferred embodiment of a circuit in accordance with the invention. The circuit is used, for example for driving vacuum fluorescence displays. A supply voltage of 5 V and -30 V is then applied to the supply voltage terminals VDD and VEE, respectively. The circuit comprises a first PMOS switching transistor T1, a second PMOS, protection transistor T2, a sub-circuit comprising two bipolar npn transistors T3 and T4 which form a Darlington output stage, and three resistors R1, R2 and R3. The PMOS transistor T1 is a conventional transistor having a drain D1 and a source S1 which are constructed as $p^+$ regions D1, S1 (see Fig. 1B) in a substrate of n-material, the gate oxide having a thickness of from 30 to 50 nm. The gate G1 receives an input signal Vin. The input signal Vin has, for example two logic levels: VDD (= 5 V) and VSS (=0 V).

The protection transistor T2 (see Fig. 1C) has a $p^-$ drain $D2p^-$ and a $p^-$ source $S2p^-$ which are connected *via* $p^+$ regions. The polysilicon gate G2 is arranged on the field oxide FO1. Consequently, as has already been explained, the transistor T2 has a threshold value (for example, $V_{T2} = -26$ V for $V_{BS} \approx 2.5$ V; $V_{T2} \approx -35$ V for $V_{BS} = 5$ V) substantially higher than that of the switching transistor T1 ($V_{T1} \approx 1$ V). The drain $D2p^-$ and the source $S2p^-$ are connected *via* A1 contacts provided in the insulating silicon oxide layer SO1.

The bipolar transistors T3 and T4 are constructed as vertical integrated transistors as appears from Fig. 1D. In the substrate SB of $n^-$ material, provided on the $n^{++}$ semiconductor substrate material as an epitaxial layer, there is formed a $p^-$ tub W. In said tub W there are formed a $p^+$ region as the base B3 and an $n^+$ region as the emitter E3,the collector C3 of the bipolar transistors T3 and T4 being connected to the supply voltage VDD *via* an $n^+$ region in the substrate SB. The use of $n^{++}$ substrate material renders the circuit less sensitive to latch-up problems. Moreover, the collector supply lead resistance is reduced, which is particularly advantageous for a Darlington output stage. The resistances R1 (10 kΩ), R2(10kΩ) and R3 (100 kΩ) can be formed as a respective $p^-$ tub in the $n^-$ layer. The resistance R3 need not be integrated. It can be connected, outside the integrated circuit between the load output O1 and the supply voltage VEE.

The circuit in accordance with the invention as shown in Fig. 1 operates as follows. When an input voltage VSS (= 0 V) is applied to the input terminal Vin, the transistor T1 is turned on. The transistor T2 is also turned on, because the gate G2 is maintained at the fixed voltage VEE (= -30 V), so that the base of the transistor T3 becomes substantially equal to $V_{DD}$. The output voltage Vout is raised *via* the Darlington pair T3 and T4 (Vout ≈ VDD -2. $V_{BE}$; $V_{BE}$ base-emitter voltage of the transistors T3 and T4). The Darlington pair T3, T4 ensures suitable drive power at the load output O1.

When the input voltage Vin is changed from 0 V to $V_{DD}$, the transistor T1 is turned off. As a result, the transistor T2 can no longer supply current. Consequently, the base of the transistor T3 drops to $V_{EE}$. The voltage at the source S2 of the protection transistor T2 also drops towards $V_{EE}$. When the voltage difference between the gate and the source of the second transistor T2 drops below the threshold voltage $V_{TX}$ (= -26 V), the protection transistor T2 is turned off. Consequently, the potential at S2 remains limited to voltages in the vicinity of $V_{DD}$. The transistor T2 is turned off before its source drops below $V_{SS}$, because (as stated) the threshold voltage $V_{T2}$ = -35 V for $V_{BS}$ = 5V. The transistor T1 is thus protected against drain and gate/drain breakdowns.

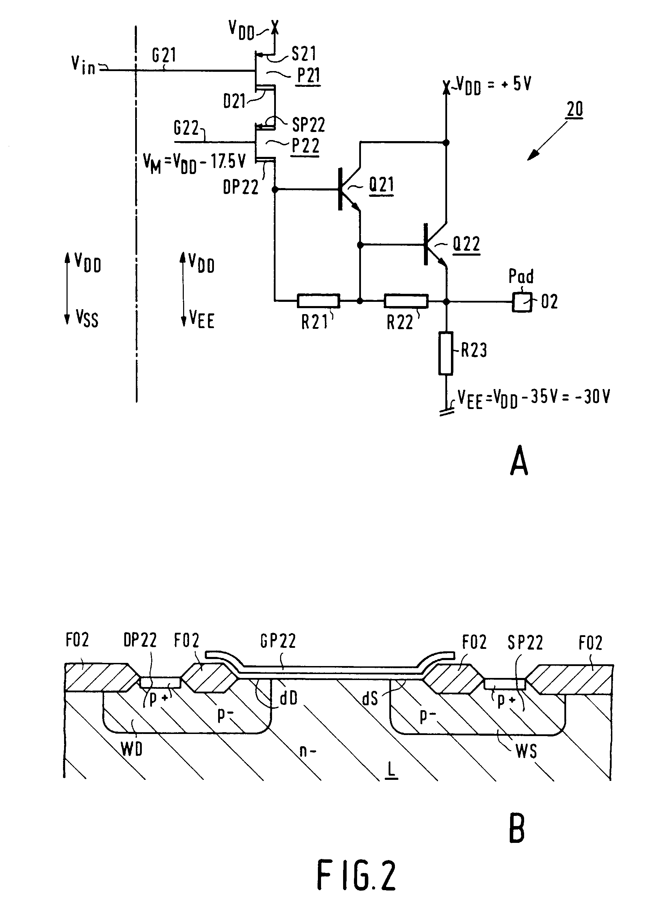

Fig. 2A shows a circuit useful for understanding the invention in which the sub-circuit (comprising transistors Q21, Q22 and resistances R21, R22 and R23) can be identical to the corresponding sub-circuit (comprising transistors T3, T4 and resistances R1, R2 and R3) of Fig. 1A and can also have the same function: impedance conversion for a load to be connected to the load output O2 (Fig. 2A), for example a vacuum fluorescence display. The transistors Q21 and Q22 are vertical npn transistors and the resistances R21, R22 and R23 may be P-well resistances. It is not absolutely necessary to integrate also the resistance R23. It can also be connected, outside the integrated circuit, between the load output O2 and the supply voltage $V_{EE}$.

Two transistors, *i.e.* a switching transistor P21 and a protection transistor P22, are connected in series between the supply voltage $V_{DD}$ and the sub-circuit comprising the transistors Q21, Q22 and the resistances R21, R22 and R23.

The control voltage $V_{in}$ varies between $V_{DD}$ and $V_{SS}$. It is applied to the gate G21 of the transistor P21. The PMOS transistor P21 is a conventional MOS transistor, except for the construction of its drain. The drain DP21 is an "extended" drain which is thus capable of withstanding higher voltages, without a breakdown occurring at the drain. An extended drain or source region is formed by using the tub material to envelop the p+ in a p-channel transistor in p-tub technology or the n+ in an n-channel transistor in n-tub technology. Thus, a higher breakdown strength of the drain or source region is obtained in the "extended" version relative to the substrate material. The protection transistor P22 comprises a gate G22 which is connected to a fixed voltage $V_M$; for example, $V_M$ = ($V_{DD}$ + $V_{EE}$)/2 in the example of Fig. 2. The extended drain and the extended source are special aspects of this transistor. Fig. 2B is a diagrammatic cross-sectional view of the transistor P22 (not to scale).

In the substrate L of n⁻ semiconductor material there are provided two tubs WD and WS of p⁻ semiconductor material, which tubs constitute the drain and the source of the transistor P22. The source and drain connections consist of p+ material. They are surrounded by the thick field oxide FO2. The gate GP22, being insulated from the n⁻ substrate $\underline{L}$ by a gate oxide layer, extends between the source and the drain and may overlap the thick field oxide layer FO2. The paths dD and dS between the field oxide FO2 and the n⁻ material are sufficiently large to make misalignment between gate and drain/source regions acceptable.

The operation of the circuit shown in Fig. 2A is as follows: when a potential $V_{SS}$ (= 0 V) is applied to the gate G21 of the transistor $\underline{P21}$, the transistor P21 is turned on and hence also the transistor P22, because the source potential approaches $V_{DD}$ (= +5 V). The voltage between the gate G22 and the source S22 amounts to approximately -17.5 V. The current flowing through the transistors P21 and P22 will turn on the Darlington transistor pair Q21 and Q22, thus driving a load connected to the load output O2.

As soon as the voltage $V_{in}$ at the gate G21 increases and reaches $V_{DD}$- I $V_{TH}$ I , the transistor $\underline{P21}$ is turned off. The voltage at the drain D21 then decreases until the gate-source voltage of the transistor P22 decreases to $V_{TH}$ (the source voltage is then slightly lower than the fixed voltage $V_M$ + 1$V_{TH}$). The drain voltage for the transistor P21 is thus limited to the range from ≥ $V_{DD}$- 17.5 + I VTH I = -11.5 V which can be withstood by an extended drain construction. The drain-gate voltage for the transistor P22 also remains below -20 V ($V_{EE}$ - $V_M$ ≈ -17.5 V). The operation of the transistor P22, therefore, is not endangered by a drain-gate breakdown.

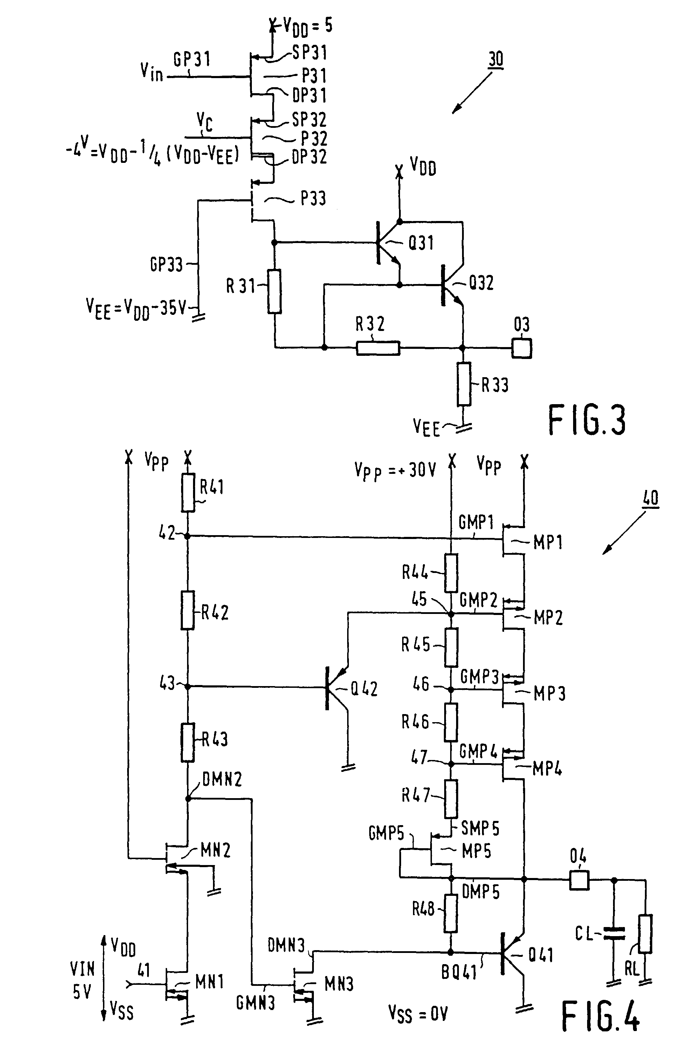

Fig. 3 shows a further embodiment of a circuit $\underline{30}$ in accordance with the invention. The circuit $\underline{30}$ comprises a switching transistor P31 and two protection transistors P32 and P33. These transistors are connected to one another and to a sub-circuit (consisting of transistors Q31, Q32 as well as resistors R31, R32 and R33), in series between the supply voltage $V_{DD}$ (+5 V) and the load output O3. The circuit $\underline{30}$ can be integrated on a semiconductor substrate, the load output O3 being connected to an output terminal of the integrated circuit, for example in order to drive a vacuum-fluorescence display.

The components Q31, Q32, R31 and R32 of the sub-circuit are identical or similar to the components T3, T4, R1 and R2 and have the same function. It is not absolutely necessary to integrate also the resistor R33. It can be connected, outside the integrated circuit, between the load output O3 and the supply voltage $V_{EE}$. The transistor P31 is a conventional MOSFET having a gate oxide layer of normal thickness (30-50 nm). Except for the extended drain (see Fig. 2B), the transistor P32 is also a conventional transistor, as is the transistor P31. The transistor P33 is a parasitic transistor whose gate GP33 is provided on the (thick) field oxide (see Fig. 1C).

The gate GP33 of the transistor P33 carries a fixed potential $V_{EE}$ ($\approx$ -30 V). The gate GP32 of the transistor P32 carries a fixed potential $V_C$ ($V_C = V_{DD} - \frac{1}{4}(V_{DD}-V_{EE})$ $\approx$ -4V). The gate GP31 of the switching transistor P31 receives the control voltage $V_{in}$ ($0 \leq V_{in} \leq 5V$). When the control voltage equals 0 V, the transistors P31, P32 and P33 are turned on and apply current to the transistors Q31 and Q32. A load connected to the load output O3 is thus driven.

When the control voltage $V_{in}$ increases to 5 V, the transistor P31 is turned off. The voltage at the drain DP31 decreases to $V_C + |1V_{TH}|$, so to $\approx$ -3 V. The potential difference between the drain DP31 and the gate GP31 or the substrate amounts to approximately 8 V; this is far less than would be required for a breakdown.

The voltage at the drain DP32 itself decreases until the transistor P33 is turned off. This occurs when $V_{EE} + |V_{TP}|$ is reached, where $V_{TP}$ is the parasitic threshold voltage. The voltage difference between the extended drain DP32 and the gate GP32 should not exceed 15 V. In other words, for a gate voltage of $V_C \approx$ -4 V, the voltage at the drain DP32 may not drop below -19 V. The threshold voltage $|V_{TP}|$ of the transistor P33 should amount to $\geq$ 11 V; this is generally the case.

Fig. 4 shows a further embodiment of a circuit 40 in accordance with the invention which can be integrated on a p-substrate. This circuit 40 comprises an NMOS switching transistor MN1, an NMOS protection transistor MN2, and a sub-circuit which is connected in series between two supply voltages $V_{PP}$ ($\approx$ + 30 V) and $V_{SS}$ (= 0 V). The sub-circuit comprises resistances R41, R42, R43, bipolar pnp transistors Q41 and Q42, a (parasitic) NMOS transistor MN3, further resistances R44, R45, R46, R47 and R48, and PMOS transistors MP1, MP2, MP3, MP4 and MP5. Fig. 4 also shows the load to be powered by the circuit 40. It concerns a capacitance CL with parallel-connected resistance RL connected to the load output O4.

The resistances R41 to R43 are connected to one another and in series with the transistors MN1 and MN2 between $V_{PP}$ and $V_{SS}$. The transistors MP1, MP2, MP3, MP4 and Q41 are connected in series between $V_{PP}$ and $V_{SS}$, the collector of the transistor Q41 being connected to $V_{SS}$ and its emitter to the drain of the transistor MP4. The sources of MP4, MP3, MP2 and MP1 are connected to a respective drain of the transistors MP3, MP2, MP1 and to $V_{PP}$. The gate GMP1 of the transistor MP1 is connected to the junction of the resistances R41 and R42. The gate GMP2 of the transistor MP2 is connected to the junction point of the resistances R44 and R45 whereto the emitter of the transistor Q42 is also connected. The collector of the transistor Q42 is connected to $V_{SS}$, its base being connected to the junction point of the resistances R42 and R43. The gates GMP3 and GMP4 of the transistors MP3 and MP4 are connected to the junction points of the resistances R45 and R46 and of R46 and R47, respectively. The source SMP5 of the transistor MP5 is connected to the resistance R47.

The gate GMP5 and the drain DMP5 are connected to one another, to the emitter of the transistor Q41 and to the output terminal O4. Furthermore, the drain DMP5 is connected to the base BQ41 via the resistance R48. The drain DMN2 is connected to the gate GMN3 of the transistor MN3 whose source is connected to $V_{SS}$ and whose drain DMN3 is connected to the base BQ41 of the transistor Q41.

In Fig. 4 a plurality of level converters are used to realize a 35 V VFD driver stage on a p substrate. The first level converter consists of MN1/MN2 plus resistances. The circuit still requires the inverted high voltage. This could be generated by inversion of the logic signal by means of the subsequent second level converter. However, it is simpler to achieve the inversion at the high voltage side by directly driving the "protection transistor". The inverter and the switching transistor can then be dispensed with. This results in the structure consisting of MN3 with the resistances R44-R48. Finally, MP1 may be considered to be a switching transistor in the context of the invention. The associated protection structure is the cascode with MP2-MP4. Instead of Q41, use could be made of a resistance (however, because of the faster switch-off, the active load Q41 offers advantages for practical applications of the VDF driver).

Q41 could be driven by a separate level converter (of the same polarity as MN3/resistances). That, however, would increase the complexity. Therefore, dual use is made of the level converter MN3/resistances. The use of the same level converter for two purposes (driving Q41 and bias for the cascodes MP2-MP4) gives rise to a conflict at output O4 on VPP. MP5, connected as a diode, serves for decoupling.

Finally, the two level converters MN1/MN2/resistances and MN3/resistances are coupled via Q42. Q42 may be considered to be a "sub-circuit" (connected this time as an emitter follower instead of a Darlington stage). When point 43 is used instead of DMN2, a suitable intermediate voltage is used instead of the full swing VSS/VPP.

The circuit 40 operates as follows: when a control voltage $V_{in} = 5$ V ($V_{SS} = 0$ V) is applied to the input 41, the switching transistor MN1 is turned on and hence also the protection transistor MN2. The transistor MN2 (and the transistor MN3) is similar to the transistor shown in Fig. 1C and deviates therefrom in that use is made of p⁻ semiconductor material instead of n⁻ semiconductor material, *etc.* The voltage at the gate GMN3 decreases to approximately $V_{SS}$, so that the transistor MN3 is turned off. The voltage at the junction point 42 decreases to approximately $3V_{PP}/4$, governed by the resistance ratio:

$$\frac{R42 + R43}{R41 + R42 + R43}$$

The voltage at the junction point 43 decreases to approximately $V_{pp}$ - 10 V, again governed by a resist-

ance ratio:

$$\frac{R43}{R41 + R42 + R43}.$$

The bipolar transistor Q42 is turned on and the voltage at the junction point 45 will amount to $V_{pp}$ - 10V + I $V_{BE}$ I , $V_{BE}$ being the base-emitter voltage of Q42. The transistors MP1 and MP2 are then turned on, like the transistors MP3 and MP4 whose gates GMP3 and GMP4 carry the same potential as the gate GMP2 because the transistor MN3 is turned off as described above. Because the transistors MP1-MP4 are turned on, the output O4 is connected to a voltage of approximately $V_{pp}$, depending on the load. It is important to ensure that no voltage differences of more than 10 V occur across the gates or across the drains and sources of MP1, MP2, MP3 and MP4. Therefore, no breakdowns are to be expected in this condition. The transistor Q41 is also turned off, because the emitter and the base BQ41 carry the same voltage. No current flows into the resistance chain R45, R46 and R47 from the output O4, because the transistor MP5 which is connected as a diode is polarized in the reverse direction. A load (in this case represented by a resistance RL and a capacitance CL) may be connected to the output O4. This load may be, for example a vacuum fluorescence display element which is powered *via* the transistors MP1-MP4.

When the control voltage at the input 41 is reset to 0 V, the transistor MN1 is turned off and the voltage at the gate GMN3 increases to $V_{pp}$. The transistor MN3 is turned on and a current will flow through the voltage divider R44-R48 and the "diode" MP5. The gate GMP1 of the transistor MP1 is connected to $V_{pp}$, so that the transistor MP1 is turned off. The transistor Q42 is turned off, because the voltage at the emitter, being connected to the point 45, is lower than the base voltage amounting to $V_{pp}$. The voltage divider R44-R48 is proportioned so that a voltage of < 10 V remains between the source and the drain of each of the transistors MP1, MP2, MP3 and MP4. As a result, in each transistor voltage stress is avoided. Breakdowns of sources and drains, in bulk, do not occur because each transistor is situated in its own n⁻ tub which is electrically connected to the relevant source.

The base of the transistor Q41 carries approximately $V_{ss}$ = 0 V. The current through the resistance R48 produces a voltage increase between the base and emitter of the transistor Q41, which is thus turned on and pulls the output O4 to approximately $V_{SS}$ + I $V_{BE}$ I.

The invention is not restricted to the described embodiments. For example, the parasitic transistors could be constructed so as to have polysilicon gates or aluminium gates.

## Claims

1. A circuit which is integrated on a semiconductor substrate and which comprises a first and a second supply voltage terminal ($V_{DD}$, $V_{EE}$; $V_{SS}$, $V_{PP}$) for application of a comparatively high voltage, an input and an ouput terminal ($V_{in}$, $V_{out}$), there also being provided a switching transistor (T1, P31, MN1), a protection transistor (T2, P33, MN2) and a sub-circuit (T3, Q31, T4, Q32, R1, R31, R2, R32, R3, R33), the gate of the switching transistor (T1, P31, MN1) being connected to the input terminal ($V_{in}$), the source of the switching transistor (T1, P31, MN1) being connected to the first supply voltage terminal ($V_{DD}$), the drain of the switching transistor (T1, P31, MN1) being coupled to the source of the protection transistor (T2, P33, MN2) such that the switching transistor and the protection transistor are connected in series and the drain of the protection transistor (T2, P33, MN2) being connected to the second supply voltage terminal via the sub-circuit (T3, Q31, T4, Q32, R1, R31, R2, R32, R3, R33) to supply a signal for the sub-circuit during operation, an output of the sub-circuit being connected to the output terminal and the gate of the protection transistor (T2, P33, MN2) being adapted to receive a fixed voltage, characterized in that the gate of the protection transistor (T2, P33, MN2) is connected to the second supply voltage terminal (VEE), the gate of the protection transistor (T2, P33, MN2) is provided on a field oxide layer (FO1) of the integrated circuit to limit the voltage at the drain of the switching transistor (T1, P31, MN1).

2. An integrated circuit as claimed in Claim 1, characterized in that the switching transistor is provided with an extended drain.

3. An integrated circuit as claimed in Claim 1 or 2, characterized in that the protection transistor is provided with an extended drain, and an extended or normal source.

4. An integrated circuit as claimed in any one of the Claims 1 to 3, characterized in that the circuit comprises a third transistor (P32) which is connected in series between the switching transistor (P31) and the protection transistor (P33), its gate being connected to a fixed voltage (VC) of a value between the gate voltage of the protection transistor and the first power supply voltage (VDD).

5. An integrated circuit as claimed in Claim 4, characterized in that the switching transistor (P31), the protection transistor (P33) and the third transistor (P32) are p-channel MOS transistors, the p⁺ drain terminal of the third transistor (P32) being situated in a p⁻ well which extends as far as the p-channel underneath the gate.

6. An integrated circuit as claimed in any one of the Claims 1 to 5, characterized in that the sub-circuit comprises a resistance (R1, R31, R2, R32, R3, R33).

7. An integrated circuit as claimed in any one of the Claims 1 to 6, characterized in that the sub-circuit comprises a current amplifier circuit (T3, Q31,T4, Q32).

8. An integrated circuit as claimed in Claim 7, characterized in that the current amplifier circuit is an emitter-follower circuit.

9. An integrated circuit as claimed in Claim 8, characterized in that the emitter-follower circuit comprises two vertical integrated bipolar transistors (T3, Q31, T4, Q32) forming a Darlington pair.

10. An integrated circuit as claimed in Claim 8 or 9, characterized in that the drain terminal of the protection transistor (T2, P33) is connected to the second supply voltage terminal (VEE) *via* a series connection of at least two resistances (R1, R31, R2, R32), the base of a bipolar transistor (T3, Q31) being connected to the junction of the series connection and the drain terminal, the emitter being connected to the junction of a first and a second resistance of the series connection and to the output.

11. An integrated circuit as claimed in Claim 10, characterized in that the base of a second bipolar transistor (T4, Q32) is connected to the emitter of the first bipolar transistor (T3, Q31), and that the emitter of the second transistor (T4, Q32) is connected to the junction of the second and a third resistance (R2, R32, R3, R33) and constitutes the output of the circuit.

12. An integrated circuit as claimed in any one of the Claims 8, 9, 10 or 11, characterized in that the bipolar transistor or transistors (T3, Q31, T4, Q32) is or are formed in a respective p⁻ well in n⁻ semiconductor material, the base terminal being formed by a p⁺ region and the emitter being formed by a n⁺ region in the p⁻ well, the collector of the transistor (T3, Q31, T4, Q32) being made of the n⁻ material.

13. An integrated circuit as claimed in any one of the Claims 10 or 11, characterized in that the resistances (R1, R31, R2, R32, R3, R33) are formed as a p⁻ well in the n⁻ material.

14. An integrated circuit as claimed in Claim 1, 2 or 3, characterized in that the drain and the source of the protection transistor (T2, P33) are formed by p⁻ wells in n⁻ material, p⁺ regions for contacting being formed in the p⁻ wells.

15. An integrated circuit as claimed in any one of the Claims 1 to 3, characterized in that the sub-circuit comprises a further switching transistor (MN3) whose source is connected to the second supply voltage terminal (VSS), whose gate is connected to the drain of the protection transistor (MN2), and whose drain is connected to the first one of a series-connected cascode of further protection transistors (MP1, MP2, MP3, MP4), the drain of the last further protection transistor (MP4) of the cascode being connected to the output, the gates of the cascode of further protection transistors (MP1, MP2, MP3, MP4) being connected *via* a series connection of resistances (R44, R45, R46, R47), the output being connected to the emitter of a switch-off transistor (Q41) whose collector is connected to the first supply voltage terminal (VSS) and whose base is connected, *via* a resistance (R48), to its emitter and to the drain of a further transistor (GMP5) whose source is connected to the second supply terminal (VPP) via the series connection of resistances (R44, R45, R46, R47), the base of the switch-off transistor (Q41) being connected to the drain of the further switching transistor (MN3), the series connection of resistances (R44, R45, R46, R47) being proportioned so that the voltages at the drain-gate junctions and at the drain-source junctions of the further switching transistor (MN3) and the further protection transistors (MP1, MP2, MP3, MP4) are limited.

**Patentansprüche**

1. Auf einem Halbleitersubstrat integrierte Schaltung mit einer ersten und zweiten Versorgungsspannungsklemme ($V_{DD}$, $V_{EE}$, $V_{SS}$, $V_{PP}$) zum Anschließen einer relativ hohen Spannung und mit einer Eingangs- und einer Ausgangsklemme ($V_{in}$, $V_{out}$), wobei auch ein Schalttransistor (T1, P31, MN1), ein Schutztransistor (T2, P33, MN2) und eine Subschaltung (T3, Q31, T4, Q32, R1, R31, R2, R32, R3, R33) vorgesehen sind, wobei das Gate des Schalttransistors (T1, P31, MN1) mit der Eingangsklemme ($V_{in}$) verbunden ist, die Source des Schalttransistors (T1, P31, MN1) mit der ersten Versorgungsspannungsklemme ($V_{DD}$) verbunden ist und die Drain des Schalttransistors (T1, P31, MN1) mit der Source des Schutztransistors (T2, P33, MN2) gekoppelt ist, so daß der Schalttransistor und der Schutztransistor in Reihe geschaltet sind, und die Drain des Schutztransistors (T2, P33, MN2) über die Subschaltung (T3, Q31, T4, Q32, R1, R31, R2, R32, R3, R33) mit der zweiten Versorgungsspannungsklemme verbunden ist, um im Betrieb ein Signal für die Subschaltung abzugeben, wobei ein Ausgang der Subschaltung mit der Ausgangsklemme verbunden ist und das Gate des Schutztransistors (T2, P33, MN2) ausgebildet ist, um eine Festspannung zu empfangen, <u>dadurch gekennzeichnet,</u> daß das Gate des Schutztransistors (T2, P33, MN2) mit der zweiten Versorgungsspannungsklemme ($V_{EE}$) verbunden ist und das Gate des Schutztransistors (T2, P33, MN2) auf einer Feldoxidschicht (FO1) der integrierten Schaltung zum Begrenzen der Spannung an der Drain des Schalttransistors (T1, P31, MN1) angeordnet ist.

2. Integrierte Schaltung nach Anspruch 1, <u>dadurch gekennzeichnet,</u> daß der Schalttransistor mit einer erweiterten Drain versehen ist.

3. Integrierte Schaltung nach Anspruch 1 oder 2, <u>dadurch gekennzeichnet,</u> daß der Schutztransistor mit einer erweiterten Drain und einer erweiterten oder normalen Source versehen ist.

4. Integrierte Schaltung nach einem der Ansprüche 1 bis 3, <u>dadurch gekennzeichnet,</u> daß die Schaltung einen dritten Transistor (P32) umfaßt, der in Reihe zwischen dem Schalttransistor (P31) und dem Schutztransistor (P33) angeordnet ist und dessen Steuerelektrode auf eine Festspannung (VC) gelegt ist, die zwischen der Gatespannung des Schutztransistors und der ersten Versorgungsspannung (VDD) liegt.

5. Integrierte Schaltung nach Anspruch 4, <u>dadurch gekennzeichnet,</u> daß der Schalttransistor (P31), der Schutztransistor (P33) und dritte Transistor (P32) p-Kanal-MOS-Transistoren sind, wobei der p$^+$-Drainanschluß des dritten Transistors (P32) in einer p$^-$-Wanne liegt, die sich bis zum p-Kanal unter dem Gate erstreckt.

6. Integrierte Schaltung nach einem der Ansprüche 1 bis 5, <u>dadurch gekennzeichnet,</u> daß die Subschaltung einen Widerstand (R1, R31, R2, R32, R3, R33) enthält.

7. Integrierte Schaltung nach einem der Ansprüche 1 bis 6, <u>dadurch gekennzeichnet,</u> daß die Subschaltung eine Stromverstärkerschaltung (T3, Q31, T4, Q32) enthält.

8. Integrierte Schaltung nach Anspruch 5, <u>dadurch gekennzeichnet,</u> daß die Stromverstärkerschaltung eine Emitterfolgerschaltung ist.

9. Integrierte Schaltung nach Anspruch 8, <u>dadurch gekennzeichnet,</u> daß die Emitterfolgerschaltung zwei vertikale integrierte bipolare Transistoren (T3, Q31, T4, Q32) enthält, die ein Darlington-Paar bilden.

10. Integrierte Schaltung nach Anspruch 6 oder 7, <u>dadurch gekennzeichnet,</u> daß der Drainanschluß des Schutztransistors (T2, P33) über eine Reihenschaltung aus zumindest zwei Widerständen (R1, R31, R2, R32) mit der zweiten Versorgungsspannungsklemme (VEE) verbunden ist, wobei die Basis eines bipolaren Transistors (T3, Q31) mit der Verbindung der Reihenschaltung und des Drainanschlusses verbunden ist und der Emitter mit der Verbindung eines ersten und eines zweiten Widerstandes der Reihenschaltung und mit dem Ausgang verbunden ist.

11. Integrierte Schaltung nach Anspruch 10, <u>dadurch gekennzeichnet,</u> daß die Basis eines zweiten bipolaren Transistors (T4, Q32) mit dem Emitter des ersten bipolaren Transistors (T3, Q31) verbunden ist und der Emitter des zweiten Transistors (T4, Q32) mit der Verbindung des zweiten und eines dritten Widerstandes (R2, R32, R3, R33) verbunden ist und den Ausgang der Schaltung bildet.

12. Integrierte Schaltung nach einem der Ansprüche 8, 9, 10 oder 11, <u>dadurch gekennzeichnet,</u> daß der bipolare Transistor oder die bipolaren Transistoren (T3, Q31, T4, Q32) in einer jeweiligen p$^-$-Wanne in n$^-$-Halbleitermaterial gebildet worden sind, wobei der Basisanschluß von einem p$^+$-Gebiet und der Emitter von einem n$^+$-Gebiet in der p$^-$-Wanne gebildet wird und wobei der Kollektor des Transistors (T3, Q31, T4, Q32) aus n$^-$-Material hergestellt wird.

13. Integrierte Schaltung nach einem der Ansprüche 10, oder 11, <u>dadurch gekennzeichnet,</u> daß die Widerstände (R1, R31, R2, R32, R3, R33) als p$^-$-Wanne im n$^-$-Material gebildet worden sind.

14. Integrierte Schaltung nach Anspruch 1, 2 oder 3, <u>dadurch gekennzeichnet,</u> daß die Drain und die Source des Schutztransistors (T2, P33) von p$^-$-Wannen in n$^-$-Material gebildet werden, wobei in den p$^-$-Wannen p$^+$-Gebiete zur Kontaktierung geformt worden sind.

15. Integrierte Schaltung nach einem der Ansprüche 1 bis 3, <u>dadurch gekennzeichnet,</u> daß die Subschaltung einen weiteren Schalttransistor (MN3) umfaßt, dessen Source mit der zweiten Versorgungsspannungsklemme (VSS) verbunden ist, dessen Gate mit der Drain des Schutztransistors (MN2) verbunden ist und dessen Drain mit der ersten aus einer in Reihe geschalteten Kaskode von weiteren Schutztransistoren (MP1, MP2, MP3, MP4) verbunden ist, wobei die Drain des letzten weiteren Schutztransistors (MP4) der Kaskode mit dem Ausgang verbunden ist, die Gates der Kaskode weiterer Schutztransistoren (MP1, MP2, MP3, MP4) über eine Reihenschaltung aus Widerständen (R44, R45, R46, R47) angeschlossen sind, der Ausgang mit dem Emitter eines Ausschalttransistors (Q41) verbunden ist, dessen Kollektor mit der ersten Versorgungsspannungsklemme (VSS) und dessen Basis, über einen Widerstand (R48), mit dessen Emitter und der Drain eines weiteren Transistors (GMP5) verbunden ist, dessen Source über die Reihenschaltung aus Widerständen (R44, R45, R46, R47) mit der zweiten Versorgungsspannungsklemme (VPP) verbunden ist, wobei die Basis des Ausschalttransistors (Q41) mit der Drain des weiteren Schalttransistors (MN3) verbunden ist, wobei die Reihenschaltung aus Widerständen (R44, R45, R46, R47) so dimensioniert ist, daß die Spannungen an den Drain-Gate-Übergängen und an den Drain-Source-Übergängen des weiteren Schalttransistors (MN3) und den weiteren Schutztransistoren (MP1, MP2, MP3, MP4) begrenzt werden.

## Revendications

1. Circuit qui est intégré sur un substrat semi-conducteur et qui comprend une première et une deuxième bornes de tension d'alimentation ($V_{DD}$, $V_{EE}$; $V_{SS}$, $V_{PP}$) pour l'application d'une tension relativement élevée, une borne d'entrée et une borne de sortie ($V_{in}$, $V_{out}$), sachant que sont également prévus un transistor de commutation (T1, P31, MN1), un transistor de protection (T2, P33, MN2) et un sous-circuit (T3, Q31, T4, Q32, R1, R31, R2, R32, R3, R33), la grille du transistor de commutation (T1, P31, MN1) étant connectée à la borne d'entrée ($V_{in}$), la source du transistor de commutation (T1, P31, MN1) étant connectée à la première borne de tension d'alimentation ($V_{DD}$), le drain du transistor de commutation (T1, P31, MN1) étant couplé à la source du transistor de protection (T2, P33, MN2) de sorte que le transistor de commutation et le transistor de protection sont connectés en série, et le drain du transistor de protection (T2, P33, MN2) étant connecté à la deuxième borne de tension d'alimentation à travers le sous-circuit (T3, Q31, T4, Q32, R1, R31, R2, R32, R3, R33) pour délivrer un signal au sous-circuit durant le fonctionnement, une sortie du sous-circuit étant connectée à la borne de sortie et la grille du transistor de protection (T2, P33, MN2) étant adaptée pour recevoir une tension fixe, caractérisé en ce que la grille du transistor de protection (T2, P33, MN2) est connectée à la deuxième borne de tension d'alimentation ($V_{EE}$), la grille du transistor de protection (T2, P33, MN2) est prévue sur une couche d'oxyde épais (F01) du circuit intégré pour limiter la tension au niveau du drain du transistor de commutation (T1, P31, MN1).

2. Circuit intégré suivant la revendication 1, caractérisé en ce que le transistor de commutation est prévu avec un drain étendu.

3. Circuit intégré suivant la revendication 1 ou 2, caractérisé en ce que le transistor de protection est prévu avec un drain étendu et une source étendue ou normale.

4. Circuit intégré suivant l'une quelconque des revendications 1 à 3, caractérisé en ce que le circuit comprend un troisième transistor (P32) qui est connecté en série entre le transistor de commutation (P31) et le transistor de protection (P33), sa grille étant connectée à une tension fixe ($V_C$) dont la valeur est comprise entre la tension de grille du transistor de protection et la première tension d'alimentation ($V_{DD}$).

5. Circuit intégré suivant la revendication 4, caractérisé en ce que le transistor de commutation (P31), le transistor de protection (P33) et le troisième transistor (P32) sont des transistors MOS à canal p, la borne de drain $p^+$ du troisième transistor (P32) étant située dans un puits $p^-$ qui s'étend aussi loin que le canal p sous la grille.

6. Circuit intégré suivant l'une quelconque des revendications 1 à 5, caractérisé en ce que le sous-circuit comprend une résistance (R1, R31, R2, R32, R3, R33).

7. Circuit intégré suivant l'une quelconque des revendications 1 à 6, caractérisé en ce que le sous-circuit comprend un circuit d'amplification de courant (T3, Q31, T4, Q32).

8. Circuit intégré suivant la revendication 7, caractérisé en ce que le circuit d'amplification de courant est un montage émetteur-suiveur.

9. Circuit intégré suivant la revendication 8, caractérisé en ce que le montage émetteur-suiveur comprend deux transistors bipolaires verticaux intégrés formant une paire Darlington.

10. Circuit intégré suivant la revendication 8 ou 9, caractérisé en ce que la borne de drain du transistor de protection (T2, P33) est connectée à la deuxième borne de tension d'alimentation ($V_{EE}$) à travers un montage en série d'au moins deux résistances (R1, R31, R2, R32), la base d'un transistor bipolaire (T3, Q31) étant connectée à la jonction du montage en série et de la borne de drain, l'émetteur étant connecté à la jonction d'une première et d'une deuxième résistances du montage en série et à la sortie.

11. Circuit intégré suivant la revendication 10, caractérisé en ce que la base d'un deuxième transistor bipolaire (T4, Q32) est connectée à l'émetteur du premier transistor bipolaire (T3, Q31) et que l'émetteur du deuxième transistor (T4, Q32) est connecté à la jonction d'une deuxième et d'une troisième résistances (R2, R32, R3, R33) et constitue la sortie du circuit.

**12.** Circuit intégré suivant l'une quelconque des revendications 8, 9, 10 ou 11, caractérisé en ce que le ou les transistors bipolaires (T3, Q31, T4, Q32) est ou sont formés dans un puits p⁻ respectif dans un matériau semi-conducteur n⁻, la borne de base étant formée par une région p⁺ et l'émetteur étant formé par une région n⁺ dans le puits p⁻, le collecteur du transistor (T3, Q31, T4, Q32) étant fait du matériau n⁻.

**13.** Circuit intégré suivant l'une quelconque des revendications 10 ou 11, caractérisé en ce que les résistances (R1, R31, R2, R32, R3, R33) sont réalisées sous la forme d'un puits p⁻ dans le matériau n⁻.

**14.** Circuit intégré suivant la revendication 1, 2 ou 3, caractérisé en ce que le drain et la source du transistor de protection (T2, P33) sont formés par des puits p⁻ dans un matériau n⁻, les régions p⁺ pour réaliser le contact étant formées dans les puits p⁻.

**15.** Circuit intégré suivant l'une quelconque des revendications 1 à 3, caractérisé en ce que le sous-circuit comprend un autre transistor de commutation (MN3) dont la source est connectée à une deuxième borne de tension d'alimentation ($V_{SS}$), dont la grille est connectée au drain du transistor de protection (MN2), et dont le drain est connecté au premier transistor d'une cascode d'autres transistors de protection (MP1, MP2, MP3, MP4) connectée en série, le drain du dernier autre transistor de protection (MP4) de la cascode étant connecté à la sortie, les grilles de la cascode des autres transistors de protection (MP1, MP2, MP3, MP4) étant connectées à travers un montage en série de résistances (R44, R45, R46, R47), la sortie étant connectée à l'émetteur d'un transistor de coupure Q41 dont le collecteur est connecté à la première borne de tension d'alimentation ($V_{SS}$) et dont la base est connectée, à travers une résistance (R48), à son émetteur et au drain d'un autre transistor (GMP5) dont la source est connectée à la deuxième borne de tension d'alimentation ($V_{PP}$) à travers le montage en série de résistances (R44, R45, R46, R47), la base du transistor de coupure (Q41) étant connectée au drain de l'autre transistor de commutation (MN3), le montage en série de résistances (R44, R45, R46, R47) étant proportionné de telle sorte que les tensions au niveau des jonctions drain-grille et au niveau des jonctions drain-source de l'autre transistor de commutation (MN3) et des autres transistors de protection (MP1, MP2, MP3, MP4) soient limitées.

FIG.1

A

B

FIG.2

FIG.3

FIG.4